# EUROPÄISCHE PATENTSCHRIFT

(11) **EP 3 640 650 B1**
(45) Veröffentlichungstag und Bekanntmachung des Hinweises auf die Patenterteilung: **02.06.2021**
(21) Anmeldenummer: 19202968.4
(22) Anmeldetag: 14.10.2019
(51) Int. Cl.: G01R 1/20, G01R 3/00

(54) **VERFAHREN ZUR HERSTELLUNG EINER WIDERSTANDSBAUGRUPPE FÜR EINEN BATTERIESENSOR UND WIDERSTANDSBAUGRUPPE**
METHOD FOR MANUFACTURING A RESISTOR UNIT FOR A BATTERY SENSOR AND RESISTOR UNIT
PROCÉDÉ DE FABRICATION D'UNE UNITÉ DE RÉSISTANCE POUR UN CAPTEUR DE BATTERIE ET UNITÉ DE RÉSISTANCE

(30) Priorität: 15.10.2018 DE 102018217601
(43) Veröffentlichungstag der Anmeldung: 22.04.2020
(73) Patentinhaber: Continental Automotive GmbH, 30165 Hannover (DE); Continental Teves AG & Co. OHG, 60488 Frankfurt am Main (DE)
(72) Erfinder: Frenzel, Henryk, 60488 Frankfurt am Main (DE); Hampl, Richard, 60488 Frankfurt am Main (DE); Möstl, Jörg, 60488 Frankfurt am Main (DE)
(74) Vertreter: Continental Corporation

(56) Entgegenhaltungen:
- EP-A2- 2 085 785
- WO-A1-2006/119953
- DE-T5-112016 001 946
- JP-A- 2002 048 821
- KR-A- 20140 046 834
- US-A1- 2011 062 945
- US-A1- 2017 222 282

## Beschreibung

Die Erfindung betrifft ein Verfahren zur Herstellung einer Widerstandsbaugruppe für einen Batteriesensor und eine mit diesem Verfahren hergestellte Widerstandsbaugruppe, wobei die Widerstandsbaugruppe ein erstes Anschlusselement, ein zweites Anschlusselement und ein Widerstandselement aufweist, das das erste Anschlusselement und das zweite Anschlusselement elektrisch miteinander verbindet.

Batteriesensoren werden in Fahrzeugen eingesetzt, um Informationen über den Batteriezustand, beispielsweise den Ladezustand der Batterie, zu erhalten. Die zu erfassenden Batterieparameter sind beispielsweise die Batteriespannung, der Batteriestrom und die Temperatur der Batterie, wobei insbesondere die Batteriespannung und der Batteriestrom permanent erfasst werden müssen, um beispielsweise eine exakte Aussage über den Zustand der Batterie, beispielsweise den Ladezustand, treffen zu können.

Die Stromerfassung erfolgt beispielsweise durch die Erfassung eines Spannungsabfalls über einen im Laststroms angeordneten Messwiderstand. Der elektrische Widerstand des Messwiderstandes ist sehr genau bekannt. Durch den erfassten Spannungsabfall kann über das ohmsche Gesetz der über den Messwiderstand fließende Strom, also der Laststrom, sehr genau ermittelt werden.

Üblicherweise wird für den Messwiderstand ein Material verwendet, das eine geringe Temperaturabhängigkeit sowie eine geringe Alterungsdrift des elektrischen Widerstandes aufweist, beispielsweise eine Kupfer-Nickel-Mangan-Legierung. Der Messwiderstand weist beispielsweise Anschlussfahnen zur Kontaktierung mit den Anschlusselementen auf.

Die Anschlusselemente sind aus einem Material mit einer hohen Leitfähigkeit hergestellt, beispielsweise aus Kupfer oder einer Kupferlegierung. Beispielsweise weist ein erstes Anschlusselement eine Batteriepolklemme auf und ein zweites Anschlusselement weist einen Kabelanschluss für ein Massekabel auf. Der Kabelanschluss für das Massekabel kann beispielsweise durch einen Kabelschuh oder durch einen Bolzen gebildet sein.

Im Stand der Technik werden die Anschlusselemente, insbesondere das zweite Anschlusselement, an dem das Massekabel befestigt wird, durch Löten, insbesondere durch Widerstandshartlöten, mit den Anschlussfahnen des Messwiderstandes verbunden. Das heißt, die Verbindung zwischen den Anschlusselementen und den Messwiderstand erfolgt durch einen zusätzliches Verbindungsmaterial, das eine formschlüssige oder stoffschlüssige Verbindung mit dem Anschlusselement und dem Messwiderstand herstellt.

Im regulären Fahrzeugbetrieb muss eine zuverlässige Kontaktierung zwischen den Anschlusselementen und dem Messwiderstand sichergestellt sein. Dies ist erforderlich, um eine zuverlässige Bestimmung des Batteriezustandes sicherzustellen. Die Verbindung zwischen dem Anschlusselement und dem Messwiderstand muss also den im Fahrzeugbetrieb auftretenden Belastungen, beispielsweise mechanische Belastungen wie Vibrationen oder Erschütterungen oder auch Temperaturschwankungen, standhalten. Insbesondere das zweite Anschlusselement, an dem das Massekabel befestigt ist, muss stabil mit dem Messwiderstand verbunden sein.

In der US 2011/062945 A1, der US 2017/0222282 A1 werden die Anschlusselemente mit dem Widerstandselement verschweißt. Zusätzlich sind Führungen oder Anschläge vorgesehen, die die Position des Anschlusselements am Widerstandselement vorgeben.

In der EP 2 085 785 A2 werden die Anschlusselemente mit dem Widerstandselement vernietet.

Aus dem Stand der Technik ist bekannt, zusätzliche Verstärkungselemente zu verwenden, die die Verbindung zwischen dem Anschlusselement und dem Messwiderstand entlasten, also die mechanischen Belastungen zumindest teilweise aufnehmen können.

Des Weiteren ist eine möglichst flexible Positionierung des zweiten Anschlusselements am Messwiderstand erwünscht, um das zweite Anschlusselement so ausrichten zu können, dass dieses beispielsweise die auf das Massekabel wirkenden Zugkräfte ideal aufnehmen kann.

Aufgabe der Erfindung ist es, eine Widerstandsbaugruppe für einen Batteriesensor bereitzustellen, der eine ausreichende Festigkeit aufweist, um den Fahrzeugbetrieb auftretenden Belastungen standzuhalten. Aufgabe der Erfindung ist es des Weiteren ein Verfahren zur Herstellung einer solchen Widerstandsbaugruppe bereitzustellen. Aufgabe der Erfindung ist es des Weiteren eine Widerstandsbaugruppe und ein Verfahren zur Herstellung eines solchen Widerstandsbaugruppe bereitzustellen, eine flexible Ausrichtung bzw. Positionierung der Anschlusselemente am Messwiderstand ermöglicht.

Zur Lösung der Aufgabe ist ein Verfahren zur Herstellung einer Widerstandsbaugruppe für einen Batteriesensor vorgesehen, wobei die Widerstandsbaugruppe ein erstes Anschlusselement, ein zweites Anschlusselement und ein Widerstandselement aufweist, das das erste Anschlusselement und das zweite Anschlusselement elektrisch miteinander verbindet. Das erste Anschlusselement und/oder das zweite Anschlusselement weisen jeweils eine erste Anschlussfläche auf und das Widerstandselement weist zumindest eine zweite Anschlussfläche auf. Die zweite Anschlussfläche ist an einem Vorsprung vorgesehen, der zumindest zwei Montagepositionen für die erste Anschlussfläche aufweist. Das Verfahren weist die folgenden Schritte auf:
- Bereitstellen des ersten Anschlusselements und/oder des zweiten Anschlusselements sowie des Widerstandselements,
- Ausrichten des ersten Anschlusselements und/oder des zweiten Anschlusselements, so dass die erste Anschlussfläche jeweils in einer der Montagepositionen an einer zweiten Anschlussfläche aufliegt, und
- Verschweißen der ersten Anschlussfläche mit der zweiten Anschlussfläche durch zumindest teilweises Aufschmelzen und anschließendes Aushärten der ersten Anschlussfläche und/oder der zweiten Anschlussfläche.

Anders als häufig im Stand der Technik, erfolgt die Herstellung der Verbindung zwischen dem jeweiligen Anschlusselement und in Widerstandselement durch Löten, sondern durch Schweißen, wobei insbesondere ein Schweißverfahren Ohne Zusatzstoffe verwendet wird. Dies hat den Vorteil, dass keine Zusatzstoffe bereitgestellt werden müssen. Es ist lediglich erforderlich, die erste Anschlussfläche und die zweite Anschlussfläche relativ zueinander auszurichten und durch Energieeintrag zumindest eine der Anschlussflächen kurzzeitig aufzuschmelzen, sodass diese mit dem Material der jeweils anderen Anschlussfläche eine stoffschlüssige Verbindung eingehen kann. Eine solche Schweißverbindung weist eine sehr hohe Festigkeit auf. Zudem muss kein zusätzliches Material zwischen den Anschlussflächen eingebracht werden.

Ein weiterer Vorteil dieses Verfahrens liegt darin, dass eine beliebige Ausrichtung des jeweiligen Anschlusselements und des Widerstandselements erfolgen kann, solange die Anschlussflächen vor dem Verschweißen aufeinander aufliegen. Das Anschlusselement kann beispielsweise bezüglich einer senkrecht zur zweiten anschlussfähig stehenden Achse verschwenkt werden, solange die erste Anschlussfläche auf der zweiten Anschlussfläche aufliegt. Dadurch ist eine flexiblere Anpassung der Widerstandsbaugruppe an die Einbaubedingungen im Fahrzeug möglich.

An der ersten Anschlussfläche und/oder an der zweiten Anschlussfläche kann zumindest eine nach dem Ausrichten in Richtung zur jeweils anderen Anschlussfläche vorstehende Materialerhebung vorgesehen sein, die beim Schweißvorgang aufgeschmolzen wird und sich anschließend verfestigt. Die Erhebung besteht vorzugsweise aus dem gleichen Material wie die Anschlussfläche. Nach dem Aufschmelzen der Erhebung kann sich das Material der Erhebung gleichmäßig zwischen den Anschlussflächen verteilen, sodass eine Verbindung über eine möglichst große Fläche erfolgt.

Die zumindest eine Materialerhebung kann vorzugsweise so angeordnet werden, dass nach dem Aufschmelzen und anschließenden Aushärten der Materialerhebung in eine bevorzugte Lastrichtung eine möglichst hohe Festigkeit erzielt wird.

Beispielsweise können auch mehrere Materialerhebungen vorgesehen sein, die gleichmäßig und/oder symmetrisch auf der Anschlussfläche verteilt sind. Die Materialerhebung kann so angeordnet sein, dass unabhängig von der Ausrichtung des Anschlusselements zum Widerstandselement eine hohe Festigkeit erzielt wird, insbesondere in einer Zugrichtung des Anschlusselements. Symmetrisch umfasst in diesem Zusammenhang jede Art von Symmetrie, beispielsweise eine Achsensymmetrie oder eine Rotationssymmetrie. Beispielsweise können die Materialerhebung bezüglich eines Mittelpunktes in Umfangsrichtung gleichmäßig verteilt angeordnet sein.

Um die Festigkeit der Verbindung zwischen dem Anschlusselement und dem Widerstandselements zu erhöhen, kann sich die Materialerhebung auch bezüglich einer Längsachse des ersten Anschlusselements und/oder des zweiten Anschlusselement in Querrichtung oder in Längsrichtung erstrecken.

Das Aufschmelzen der Materialerhebung erfolgt beispielsweise durch eine Energieeinleitung. Beispielsweise erfolgt die Energieanleitung so, dass zwischen dem jeweiligen Anschlusselement und dem Widerstandselement ein Energiefluss erfolgt. Da die erste Anschlussfläche und die zweite Anschlussfläche lediglich mit den Materialerhebungen aneinander anlegen, erfolgt an diesen Materialerhebungen eine Konzentrierung des Energieflusses, die zu einer starken lokalen Erwärmung und somit zu einem Aufschmelzen des Materials der Materialerhebungen führt. Dadurch ist ein Verschweißen der Anschlussflächen möglich, auch wenn diese nicht direkt erreichbar sind. Insbesondere kann die Energieeinleitung durch das Einleiten von Strom zwischen dem Widerstandselement und dem Anschlusselement, also durch ein Widerstandsschweißverfahren, erfolgen.

Alternativ kann das Schweißen der ersten Anschlussfläche mit der zweiten Anschlussfläche aber auch durch ein Laserschweißverfahren erfolgen.

Um eine möglichst flexible Positionierung des Anschlusselements am Widerstandselement zu ermöglichen, ist die zweite Anschlussfläche vorzugsweise an einem Vorsprung vorgesehen, der insbesondere zumindest zwei Montagepositionen für die erste Anschlussfläche aufweist. Der Vorsprung ist so ausgebildet, dass das Anschlusselement bezüglich einer senkrecht zur zweiten Anschlussfläche stehenden Achse verschwenkt werden kann, wenn die erste Anschlussfläche auf die zweite Anschlussfläche aufgelegt ist. Dadurch ist eine flexible Ausrichtung des jeweiligen Anschlusselements am Widerstandselement möglich.

Um eine möglichst stabile Verbindung durch das Schweißen herzustellen, bestehen die erste Anschlussfläche und die zweite Abschlussfläche vorzugsweise aus dem gleichen Material, sodass nach dem Schweißen eine einstückige Verbindung hergestellt ist. Insbesondere kann das Material Kupfer oder eine Kupferlegierung sein.

Zur Lösung der Aufgabe ist des Weiteren eine Widerstandsbaugruppe für einen Batteriesensor, mit einem ersten Anschlusselement, einen zweiten Anschlusselement und einem Widerstandselement, das das erste Anschlusselement und zweite Anschlusselement elektrisch miteinander verbindet. Das erste Anschlusselement und/oder das zweite Anschlusselement weisen eine erste Anschlussfläche auf und das Widerstandselement weist zumindest eine zweite Anschlussfläche auf, wobei die zweite Anschlussfläche an einem Vorsprung vorgesehen ist, der zwei Montagepositionen für die erste Anschlussfläche aufweist, wobei die erste Anschlussfläche des ersten Anschlusselements und/oder des zweiten Anschlusselement jeweils mit einer zweiten Anschlussfläche des Widerstandselements in einer der Montagepositionen durch ein Schweißverfahren, insbesondere nach einem der vorhergehenden Ansprüche, elektrisch und mechanisch verbunden ist.

Die zumindest eine erste Anschlussfläche und die zumindest eine zweite Anschlussfläche sind vorzugsweise aus dem gleichen Material, insbesondere aus Kupfer oder eine Kupferlegierung, hergestellt.

Weitere Vorteile und Merkmale ergeben sich aus der nachfolgenden Beschreibung in Verbindung mit den beigefügten Zeichnungen. In diesem zeigen:
- Figur 1: eine perspektivische Darstellung eines Batteriesensors mit einer erfindungsgemäßen Widerstandsbaugruppe;
- Figur 2: eine schematische Darstellung der Widerstandsbaugruppe des Batteriesensors aus Figur 1;
- Figuren 3a - 3c: Verfahrensschritte zur Herstellung der Widerstandsbaugruppe aus Figur 2;
- Figur 4: eine schematische Darstellung verschiedener Positionen des zweiten Anschlusselements am Widerstandselement; und
- Figuren 5a - 5e: Ausführungsformen eines Anschlusselements für die Widerstandsbaugruppe aus Figur 2.

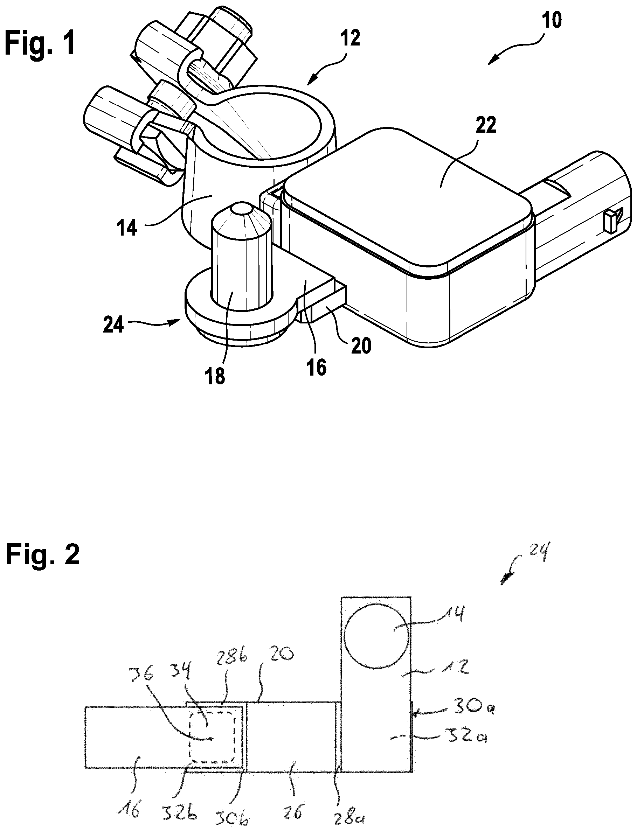

In Figur 1 ist ein Batteriesensor 10 gezeigt, mit einem ersten Anschlusselement 12, das eine Batteriepolklemme 14 aufweist, einem zweiten Anschlusselement 16, das einen Kabelanschluss 18 für ein Massekabel aufweist, sowie mit einem Widerstandselement 20, das das erste Anschlusselement 12 und das zweite Anschlusselement 16 elektrisch miteinander verbindet. Des Weiteren ist eine hier nicht im Detail dargestellte, in einem Gehäuse 22 angeordnete Erfassungseinrichtungen für zumindest einen Batterieparameter, insbesondere eine Spannungserfassungseinrichtung zur Erfassung eines Spannungsabfalls Über dem Widerstandselement aufgrund eines zwischen dem ersten Anschlusselement und dem zweiten Anschlusselement fließenden Stroms vorgesehen. Aus dem erfassten Spannungsabfall und den bekannten elektrischen Widerstand des Widerstandselement 20 kann der zwischen dem ersten Anschlusselement 12 und dem zweiten Anschlusselement 16, also über den Batteriesensor 10, fließende Laststrom ermittelt werden.

Das erste Anschlusselement 12, das zweite Anschlusselement 16 und das Widerstandselement 20 bilden gemeinsam eine Widerstandsbaugruppe 24, die schematisch in Figur 2 dargestellt ist. An dieser Widerstandsbaugruppe 24 werden bei der Herstellung des Batteriesensors die Erfassungseinrichtungen sowie das Gehäuse montiert.

Wie in Figur 2 zu sehen ist, weist das Widerstandselement 20 einen Messwiderstand 26 auf, der aus einem Material besteht, das eine geringe Abhängigkeit des elektrischen Widerstandes von der Temperatur sowie eine geringe Alterungsdrift des elektrischen Widerstandes aufweist. Beispielsweise ist der Messwiderstand 26 aus einer Kupfer-Nickel-Mangan-Legierung hergestellt. Des Weiteren weist das Widerstandselement 20 zwei Kontaktbereiche 28a, 28b zur Kontaktierung mit dem ersten Anschlusselement 12 und den zweiten Anschlusselement 16 auf.

Die Anschlusselemente 12, 16 weisen jeweils eine erste Anschlussfläche 30a, 30b auf, mit der die Anschlusselemente 12, 16 an einer zweiten, jeweils an den Kontaktbereichen 28a, 28b vorgesehenen Anschlussfläche 32a, 32b mit dem Widerstandselement 20 verbunden sind. Die Verbindung zwischen den Anschlusselementen 12, 16 erfolgt bisher mit einem Hartlötverfahren (Brazing), bei dem ein Lötmaterial zwischen den ersten Anschlussflächen 30a, 30b und den zweiten Anschlussflächen 32a, 32b eingebracht und aufgeschmolzen wird.

Bei der in den Figur 2 dargestellten Widerstandsbaugruppe 24 erfolgt die Verbindung der Anschlusselemente 12, 16 mit dem Widerstandselement 20 mit einem Schweißverfahren ohne zusätzlichen Materialeintrag. Hierzu sind die Kontaktbereiche 28a, 28b, insbesondere die zweiten Anschlussflächen 32a, 32b und die ersten Anschlussflächen 30a, 30b aus dem gleichen Material hergestellt, beispielsweise einer Kupferlegierung oder aus Kupfer.

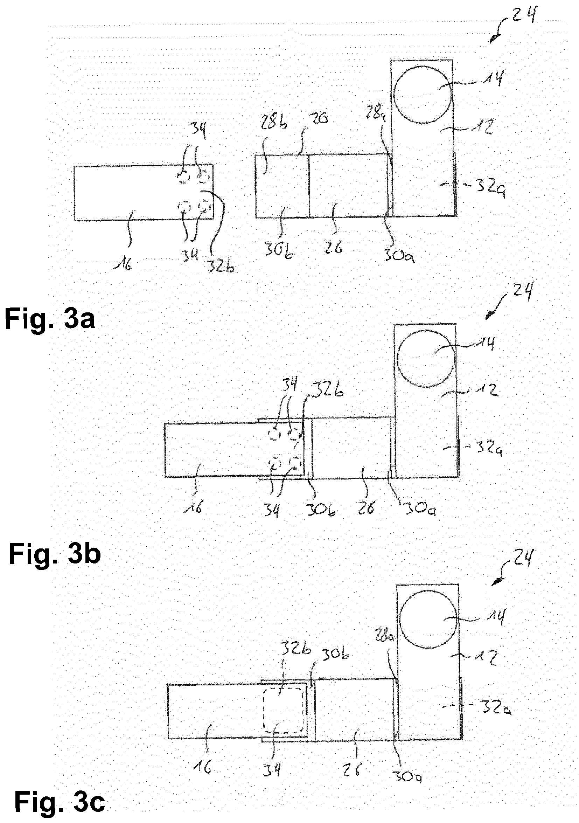

Das Schweißverfahren wird nachfolgend anhand der Figuren 3a bis 3c beschrieben, wobei hier nur die Verbindung zwischen dem zweiten Anschlusselement 16 und dem Widerstandselement 20 beschrieben wird. Das erste Anschlusselement 12 ist bereits mit dem Widerstandselement 20 verbunden, wobei dies auf die gleiche Weise erfolgen kann, die nachfolgend für die Herstellung der Verbindung zwischen den zweiten Anschlusselement 16 und dem Widerstandselement 20 beschrieben wird.

In einem ersten Verfahrensschritt werden das Anschlusselement 16 sowie das Widerstandselement 20 bereitgestellt. Wie insbesondere in Figur 3a zu sehen ist sind an der ersten Anschlussfläche 30a mehrere Materialerhebungen 34 vorgesehen, die in Richtung zur zweiten Anschlussfläche 32a vorstehen. Diese Materialerhebungen bestehen aus dem gleichen Material wie die Anschlussfläche 30a.

Das zweite Anschlusselement 16 wird anschließend relativ zum Widerstandselement 20 ausgerichtet, wobei die erste Anschlussfläche 30a auf der zweiten Anschlussfläche 32a aufliegt. Da die Materialerhebungen 34 von der ersten Anschlussfläche 30a vorstehen, liegt die erste Anschlussfläche 30a nicht flächig auf der zweiten Anschlussfläche 32a, sondern lediglich mit den Materialerhebungen 34.

Wie in Figur 3a des Weiteren zu sehen ist, ragt die zweite Anschlussfläche 32a so hervor, dass diese auch bezüglich einer Längsachse 34 des Widerstandselement 20 seitlich zugänglich ist.

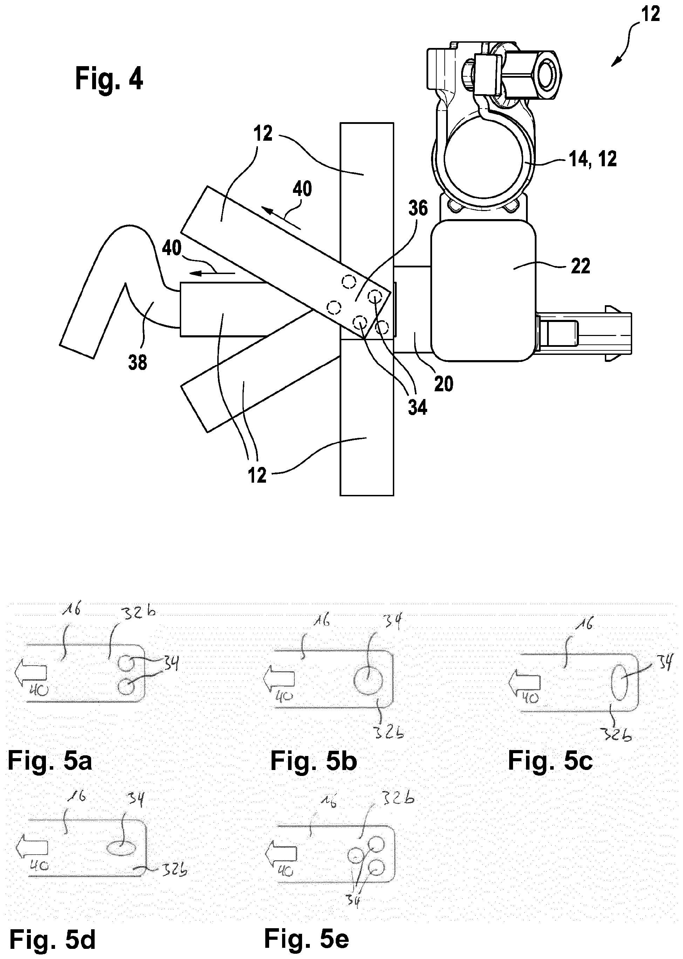

Dies ermöglicht eine freie Ausrichtung des zweiten Anschlusselement 16 relativ zum Widerstandselement 20. insbesondere kann das Anschlusselement 16 bezüglich einer Drehachse 36, die senkrecht auf der zweiten Anschlussfläche 32a steht, verschwenkt werden, sodass eine Ausrichtung des zweiten Anschlusselement 16, beispielsweise in Richtung eines abgehenden Massekabels 38 erfolgen kann (siehe Figur 4).

Nach dem Ausrichten des zweiten Anschlusselement 16 am Widerstandselement 20 erfolgt ein Verschweißen der ersten Anschlussfläche 30a und der zweiten Anschlussfläche 32a durch Aufschmelzen der Materialerhebungen 34 und anschließendes Aushärten des Materials der Materialerhebungen 34. Da die Anschlussflächen 30a, 32a und die Materialerhebungen 34 aus dem gleichen Material bestehen, entsteht durch das anschließende Aushärten des Materials der Materialerhebungen 34 eine formschlüssige, insbesondere einstückige Verbindung zwischen den Anschlussflächen 30a, 32a, also dem zweiten Anschlusselement 16 und dem Widerstandselement 20, die eine sehr hohe Festigkeit aufweist.

Das Aufschmelzen der Materialerhebungen 34 erfolgt insbesondere durch einen hohen Energieeintrag auf die Materialerhebungen 34. Der Energieeintrag kann beispielsweise durch Herstellen eines Energieflusses zwischen dem zweiten Anschlusselement 16 und dem Widerstandselement 20 erfolgen. Da diese zunächst nur über die Materialerhebungen 34, die an der zweiten Anschlussfläche 32a anliegen, kontaktiert ist, erfolgt an den Materialerhebungen 34 eine Konzentration des Energieflusses, die zu einer starken lokalen Erwärmung der Materialerhebungen 34 und somit zu einem Aufschmelzen der Materialerhebungen 34 führt.

Beispielsweise erfolgt der Energieeintrag durch das Anlegen eines Stroms zwischen dem zweiten Anschlusselement 16 und dem Widerstandselement 20. Aufgrund des geringen Querschnitts der Materialerhebungen 34 im Vergleich zum Anschlusselement 16 bzw. im Vergleich zum Widerstandselement 20 erfolgt durch den Strom eine starke lokale Erwärmung der Materialerhebungen 34.

Alternativ kann auch jedes andere Verfahren verwendet werden, das zu einer Erwärmung und seinem Aufschmelzen der Materialerhebungen 34 führt, beispielsweise auch ein Laserschweißverfahren.

In den hier gezeigten Ausführungsformen sind die Materialerhebungen 34 jeweils am zweiten Anschlusselement 16 angeordnet. Dies hat den Vorteil, dass eine Anordnung der Materialerhebungen 34 so erfolgen kann, dass das aufgeschmolzene und anschließend erhärtete Material der Materialerhebungen 34 auf das Massekabel 38 wirkende Kräfte, insbesondere Zugkräfte, ideal aufnehmen kann, unabhängig von der Positionierung bzw. der Ausrichtung des zweiten Anschlusselements 16 am Widerstandselement 20.

Unabhängig davon können die Materialerhebungen 34 aber auch am Widerstandselement 20 vorgesehen sein.

Insbesondere können die Materialerhebungen 34 so angeordnet werden, dass eine ideale Lastaufnahme durch das aufgeschmolzene und anschließend erhärtete Material der Materialerhebungen 34 erfolgen kann. In den Figuren 5a bis 5e sind verschiedene Ausführungsformen für Materialerhebungen 34 vorgesehen.

In Figur 5a sind beispielsweise lediglich zwei, bezüglich der vorherrschenden Lastrichtung 40 quer verteilte Materialerhebungen 34 vorgesehen.

In Figur 5b ist lediglich eine große, kreisförmige Materialerhebungen 34 vorgesehen.

In den Figuren 5c und 5d ist jeweils eine Materialerhebungen 34 vorgesehen, die sich quer bzw. längs zur Lastrichtung 40 erstreckt.

In Figur 5e sind drei in einem Dreieck angeordnete Materialerhebungen 34 vorgesehen.

## Patentansprüche

1. Verfahren zur Herstellung einer Widerstandsbaugruppe (24) für einen Batteriesensor (10), mit einem ersten Anschlusselement (12), einen zweiten Anschlusselement (16) und einem Widerstandselement (20), das das erste Anschlusselement (12) und zweite Anschlusselement (16) elektrisch miteinander verbindet, wobei das erste Anschlusselement (12) und/oder das zweite Anschlusselement (16) eine erste Anschlussfläche (30a, 30b) und das Widerstandselement (20) zumindest eine zweite Anschlussfläche (32a, 32b) aufweist, wobei die zweite Anschlussfläche (32a, 32b) an einem Vorsprung vorgesehen ist, der insbesondere zwei Montagepositionen für die erste Anschlussfläche (30a, 30b) aufweist mit folgenden Schritten:
- Bereitstellen des ersten Anschlusselement (12) und/oder des zweiten Anschlusselements (16) sowie des Widerstandselements (20),
- Ausrichten des ersten Anschlusselements (12) und/oder des zweiten Anschlusselement (16), so dass die erste Anschlussfläche (30a, 30b) jeweils in einer der Montagepositionen an einer zweiten Anschlussfläche (32a, 32b) aufliegt, und
- Verschweißen der ersten Anschlussfläche (30a, 30b) mit der zweiten Anschlussfläche (32a, 32b) durch zumindest teilweises Aufschmelzen und anschließendes Aushärten der ersten Anschlussfläche (30a, 30b) oder der zweiten Anschlussfläche (32a, 32b) .

2. Verfahren nach Anspruch 1, **dadurch gekennzeichnet, dass** an der ersten Anschlussfläche (30a, 30b) und/oder an der zweiten Anschlussfläche (32a, 32b) zumindest eine nach dem Ausrichten in Richtung zur jeweils anderen Anschlussfläche (32a, 32b, 30a, 30b)vorstehende Materialerhebung (34) in vorgesehen ist, die beim Schweißvorgang aufgeschmolzen wird und sich anschließend verfestigt.

3. Verfahren nach Anspruch 2, **dadurch gekennzeichnet, dass** mehrere Materialerhebungen (34) vorgesehen sind, die gleichmäßig und/oder symmetrisch auf der Anschlussfläche (30a, 30b, 32a, 32b) verteilt sind.

4. Verfahren nach einem der Ansprüche 2 und 3, **dadurch gekennzeichnet, dass** sich die Materialerhebungen (34) bezüglich einer Längsachse des ersten Anschlusselements (12) und/oder des zweiten Anschlusselements (16) in Querrichtung oder in Längsrichtung erstrecken.

5. Verfahren nach einem der Ansprüche 2 bis 4, **dadurch gekennzeichnet, dass** das Aufschmelzen der Materialerhebung (34) in durch eine Energieeinleitung erfolgt, insbesondere durch das Einleiten von Strom.

6. Verfahren nach einem der vorhergehenden Ansprüche, **dadurch gekennzeichnet, dass** das Schweißen mit einem Laserschweißverfahren erfolgt.

7. Verfahren nach einem der vorhergehenden Ansprüche, **dadurch gekennzeichnet, dass** die ersten Anschlussfläche (30a, 30b) und die zweiten Anschlussfläche (32a, 32b) aus dem gleichen Material bestehen, insbesondere aus einer Kupferlegierung.

8. Widerstandsbaugruppe (24) für einen Batteriesensor (10), mit einem ersten Anschlusselement (12), einen zweiten Anschlusselement (16) und einem Widerstandselement (20), das das erste Anschlusselement (12) und zweite Anschlusselement (16) elektrisch miteinander verbindet, wobei das erste Anschlusselement (12) und/oder das zweite Anschlusselement (16) eine erste Anschlussfläche (30a, 30b) und das Widerstandselement (20) zumindest eine zweite Anschlussfläche (32a, 32b) aufweist, wobei die zweite Anschlussfläche (32a, 32b) an einem Vorsprung vorgesehen ist, der insbesondere zwei Montagepositionen für die erste Anschlussfläche (30a, 30b) aufweist, wobei die erste Anschlussfläche (30a, 30b) des ersten Anschlusselements (12) und/oder des zweiten Anschlusselement (16) jeweils mit einer zweiten Anschlussfläche (32a, 32b) des Widerstandselements (20) in einer der Montagepositionen durch ein Schweißverfahren, insbesondere nach einem der vorhergehenden Ansprüche, elektrisch und mechanisch verbunden ist.

9. Widerstandsbaugruppe nach Anspruch 8, **dadurch gekennzeichnet, dass** die die zumindest eine erste Anschlussfläche (30a, 30b) und die zumindest eine zweite Anschlussfläche (32a, 32b) aus dem gleichen Material, insbesondere aus einer Kupferlegierung, hergestellt sind.

## Claims

1. Method for producing a resistor assembly (24) for a battery sensor (10), comprising a first connection element (12), a second connection element (16) and a resistor element (20) which electrically connects the first connection element (12) and the second connection element (16) to one another, wherein the first connection element (12) and/or the second connection element (16) have/has a first connection area (30a, 30b) and the resistor element (20) has at least one second connection area (32a, 32b), wherein the second connection area (32a, 32b) is provided on a projection which has, in particular, two mounting positions for the first connection area (30a, 30b), comprising the following steps:
- providing the first connection element (12) and/or the second connection element (16) and also the resistor element (20),
- orienting the first connection element (12) and/or the second connection element (16), so that the first connection area (30a, 30b) each rest on a second connection area (32a, 32b) in one of the mounting positions, and
- welding the first connection area (30a, 30b) to the second connection area (32a, 32b) by at least partially melting and then curing the first connection area (30a, 30b) or the second connection area (32a, 32b).

2. Method according to Claim 1, **characterized in that** at least one raised material portion (34), which protrudes in the direction of the respectively other connection area (32a, 32b, 30a, 30b) after the orientation, is provided on the first connection area (30a, 30b) and/or on the second connection area (32a, 32b) and is melted and then solidifies during the welding process.

3. Method according to Claim 2, **characterized in that** a plurality of raised material portions (34) which are distributed uniformly and/or symmetrically over the connection area (30a, 30b, 32a, 32b) are provided.

4. Method according to either of Claims 2 and 3, **characterized in that** the raised material portions (34) extend in the transverse direction or in the longitudinal direction with respect to a longitudinal axis of the first connection element (12) and/or the second connection element (16).

5. Method according to one of Claims 2 to 4, **characterized in that** the raised material portion (34) melts due to an introduction of energy, in particular due to the introduction of current.

6. Method according to one of the preceding claims, **characterized in that** the welding is performed by way of a laser welding process.

7. Method according to one of the preceding claims, **characterized in that** the first connection area (30a, 30b) and the second connection area (32a, 32b) consist of the same material, in particular of a copper alloy.

8. Resistor assembly (24) for a battery sensor (10), comprising a first connection element (12), a second connection element (16) and a resistor element (20) which electrically connects the first connection element (12) and the second connection element (16) to one another, wherein the first connection element (12) and/or the second connection element (16) have/has a first connection area (30a, 30b) and the resistor element (20) has at least one second connection area (32a, 32b), wherein the second connection area (32a, 32b) is provided on a projection which has, in particular, two mounting positions for the first connection area (30a, 30b), wherein the first connection area (30a, 30b) of the first connection element (12) and/or of the second connection element (16) are each electrically and mechanically connected to a second connection area (32a, 32b) of the resistor element (20) in one of the mounting positions by a welding process, in particular according to one of the preceding claims.

9. Resistor assembly according to Claim 8, **characterized in that** the at least one first connection area (30a, 30b) and the at least one second connection area (32a, 32b) are produced from the same material, in particular from a copper alloy.

## Revendications

1. Procédé de production d'un module résistif (24) destiné à un capteur de batterie (10) et comprenant un premier élément de raccordement (12), un deuxième élément de raccordement (16) et un élément résistif (20) qui relie le premier élément de raccordement (12) et le deuxième élément de raccordement (16) électriquement l'un à l'autre, le premier élément de raccordement (12) et/ou le deuxième élément de raccordement (16) comportant une première surface de raccordement (30a, 30b) et l'élément résistif (20) comportant au moins une deuxième surface de raccordement (32a, 32b), la deuxième surface de raccordement (32a, 32b) étant prévue sur une saillie qui présente en particulier deux positions de montage pour la première surface de raccordement (30a, 30b), le procédé comportant les étapes suivantes :
- fournir le premier élément de raccordement (12) et/ou le deuxième élément de raccordement (16) et l'élément résistif (20),
- orienter le premier élément de raccordement (12) et/ou le deuxième élément de raccordement (16) de sorte que la première surface de raccordement (30a, 30b) vienne en appui sur une deuxième surface de raccordement (32a, 32b) dans l'une des positions de montage, et
- souder la première surface de raccordement (30a, 30b) à la deuxième surface de raccordement (32a, 32b) par fusion au moins partielle puis laisser durcir la première surface de raccordement (30a, 30b) ou la deuxième surface de raccordement (32a, 32b).

2. Procédé selon la revendication 1, **caractérisé en ce qu'**au moins une élévation de matière (34), qui fait saillie après l'orientation en direction de l'autre surface de raccordement respective (32a, 32b, 30a, 30b), est prévue sur la première surface de raccordement (30a, 30b) et/ou sur la deuxième surface de raccordement (32a, 32b) et est fondue pendant le processus de soudage puis se solidifie.

3. Procédé selon la revendication 2, **caractérisé en ce que** plusieurs élévations de matière (34) sont prévues qui sont réparties uniformément et/ou symétriquement sur la surface de raccordement (30a, 30b, 32a, 32b).

4. Procédé selon l'une des revendications 2 et 3, **caractérisé en ce que** les élévations de matière (34) s'étendent dans la direction transversale ou dans la direction longitudinale par rapport à un axe longitudinal du premier élément de raccordement (12) et/ou du deuxième élément de raccordement (16).

5. Procédé selon l'une des revendications 2 à 4, **caractérisé en ce que** la fusion de l'élévation de matière (34) est réalisée par apport d'énergie, notamment par apport de courant.

6. Procédé selon l'une des revendications précédentes, **caractérisé en ce que** le soudage est effectué par un procédé de soudage au laser.

7. Procédé selon l'une des revendications précédentes, **caractérisé en ce que** la première surface de raccordement (30a, 30b) et la deuxième surface de raccordement (32a, 32b) sont en la même matière, notamment en un alliage de cuivre.

8. Module résistif (24) destiné à un capteur de batterie (10) et comprenant un premier élément de raccordement (12), un deuxième élément de raccordement (16) et un élément résistif (20) qui relie le premier élément de raccordement (12) et le deuxième élément de raccordement (16) électriquement l'un à l'autre, le premier élément de raccordement (12) et/ou le deuxième élément de raccordement (16) comportant une première surface de raccordement (30a, 30b) et l'élément résistif (20) comportant au moins une deuxième surface de raccordement (32a, 32b), la deuxième surface de raccordement (32a, 32b) étant prévue sur une saillie qui présente en particulier deux positions de montage pour la première surface de raccordement (30a, 30b), la première surface de raccordement (30a, 30b) du premier élément de raccordement (12) et/ou du deuxième élément de raccordement (16) étant chacune reliées électriquement et mécaniquement à une deuxième surface de raccordement (32a, 32b) de l'élément résistif (20) dans l'une des positions de montage par un procédé de soudage, en particulier selon l'une des revendications précédentes.

9. Module résistif selon la revendication 8, **caractérisé en ce que** l'au moins une première surface de raccordement (30a, 30b) et l'au moins une deuxième surface de raccordement (32a, 32b) sont réalisées dans la même matière, notamment dans un alliage de cuivre.
